# EUROPÄISCHE PATENTSCHRIFT

(11) **EP 1 586 223 B1**
(45) Veröffentlichungstag und Bekanntmachung des Hinweises auf die Patenterteilung: **16.08.2006**
(21) Anmeldenummer: 04703784.1
(22) Anmeldetag: 21.01.2004
(51) Int. Cl.: H05K 3/30

(54) **ELEKTRISCHES VERBINDUNGSELEMENT, INSBESONDERE FÜR ELEKTRO WER KZEUGSCHALTER**
ELECTRICAL CONNECTION ELEMENT, ESPECIALLY FOR ELECTRIC TOOL SWITCHES
CONNECTEUR ELECTRIQUE DESTINE NOTAMMENT AU COMMUTATEUR D'UN OUTIL ELECTRIQUE

(30) Priorität: 22.01.2003 DE 10302305
(43) Veröffentlichungstag der Anmeldung: 19.10.2005
(73) Patentinhaber: Marquardt GmbH, 78604 Rietheim-Weilheim (DE)
(72) Erfinder: BROGHAMMER, Peter, 78573 Wurmlingen (DE); WAHL, Peter, 78056 Villingen-Schwenningen (DE)
(74) Vertreter: Otten, Herbert
(86) Internationale Anmeldenummer: PCT/EP2004/000445
(87) Internationale Veröffentlichungsnummer: WO 2004/066696

(56) Entgegenhaltungen:
- EP-A- 0 930 812
- WO-A-02/078029
- US-A- 4 655 516
- US-B1- 6 224 399
- PATENT ABSTRACTS OF JAPAN vol. 018, no. 277 (E-1554), 26. Mai 1994 (1994-05-26) & JP 06 052911 A (MITSUBISHI ELECTRIC CORP), 25. Februar 1994 (1994-02-25)

## Beschreibung

Die Erfindung betrifft einen elektrischen Schalter nach dem Oberbegriff des Patentanspruchs 1.

In beispielsweise aus der WO 02/078029 A1 bekannten Elektrowerkzeugschaltern, wie solchen für ein Akku-Elektrowerkzeug, befindet sich neben dem Kontaktsystem häufig eine elektronische Steuerschaltung zur Ansteuerung des Elektromotors im Elektrowerkzeug. Zur Versorgung der Steuerschaltung mit elektrischer Spannung dienen elektrische Verbindungselemente, wobei die Verbindungselemente einerseits mit entsprechenden Kontaktflächen für die Steuerschaltung und andererseits mit Zuleitungen für die elektrische Spannung zum Schalter kontaktieren. Die Zuleitungen können gleichzeitig als Anschlüsse für die Zuführung der elektrischen Spannung zum Kontaktsystem des Schalters dienen, so daß die elektrische Spannung für die Steuerschaltung schaltbar ist.

Bei Elektrowerkzeugschaltern ist eine solide und sichere elektrische Verbindung zwischen den Zuleitungen für die Spannung, insbesondere denjenigen zum Kontaktsystem, und den Kontaktflächen für die Steuerschaltung besonders wichtig. Dies gilt insbesondere für Schalter in Akku-Elektrowerkzeugen aufgrund der dort fließenden sehr hohen elektrischen Ströme. Die Herstellung einer solchen soliden Verbindung erfordert einen hohen Aufwand in der Fertigung des Schalters und bereitet Probleme in der Handhabung während der Montage des Schalters. Insbesondere ist ein Lötprozeß für die Herstellung der Verbindung im Verlaufe der Fertigung des Schalters unerwünscht, da dabei die Gefahr einer unzulässigen Aufheizung von benachbarten Bauteilen in der Steuerschaltung sowie von Flussmittelspritzern besteht. Auch ist oft die Zugänglichkeit o. dgl. im elektrischen Schalter für die Herstellung der Verbindung beeinträchtigt.

Ein elektrisches Verbindungselement, das zu einer Kontaktfläche auf einer Leiterplatte führt, ist aus der DE 32 33 225 A1 bekannt. Das Verbindungselement besitzt einen aus Metall bestehenden Stift, der mit der Kontaktfläche verbunden ist. Nachteilig ist die aufwendige sowie wenig präzise Montage bei diesem Verbindungselement.

Ein präziser montierbares, SMD(Surface Mounted Device)-fähiges elektrisches Verbindungselement für eine Leiterplatte ist in der US 6 224 399 B1 gezeigt. Dieses elektrische Verbindungselement besitzt vier Stifte, die in einem streifenförmigen Fixierelement aus Isoliermaterial befestigt sind. Die Stifte sind mittels des Fixierelements für die Kontaktierung zu den zugehörigen Kontaktflächen ausgerichtet und ragen beidseitig aus dem Fixierelement heraus. Auf die Stifte ist ein Stecker aufsteckbar, womit dieses Verbindungselement dem Zweck dient, ein Gegenelement für einen Stecker zu bilden. Eine Anregung zur Verwendung des Verbindungselements in einem elektrischen Schalter für ein Elektrowerkzeug entnimmt man diesem Dokument jedoch nicht.

Der Erfindung liegt die Aufgabe zugrunde, den elektrischen Schalter im Hinblick auf dessen Montagefreundlichkeit weiterzuentwickeln. Insbesondere soll ein einfach handhabbares elektrisches Verbindungselement zum Einsatz in Elektrowerkzeugschaltern kommen.

Diese Aufgabe wird durch die Merkmale des Anspruchs 1 gelöst.

Der erfindungsgemäße elektrische Schalter ist mit einem modulartig ausgestalteten elektrischen Verbindungselement versehen, das wenigstens einen aus Metall bestehenden Stift sowie ein aus einem elektrisch nichtleitenden Material bestehendes Fixierelement umfaßt. Der Stift ist derart im Fixierelement befestigt, daß der Stift zum einen zu der zugehörigen Kontaktfläche sowie der Zuleitung ausgerichtet ist und zum anderen beidseitig aus dem Fixierelement zur Kontaktierung mit der Kontaktfläche sowie der Zuleitung herausragt. Die Kontaktierung mit der Kontaktfläche kann dabei insbesondere in der Art von SMD(Surface Mounted Device)-Technik erfolgen. Vorteilhafterweise läßt sich ein solches Verbindungselement in einfacher Art und Weise bei der Herstellung des Schalters handhaben sowie montieren. Weitere Ausgestaltungen der Erfindung, vor allem im Hinblick auf die einfache Handhabung bei der Montage des Verbindungselements, sind Gegenstand der Unteransprüche.

Es bietet sich an, sämtliche zur Spannungsversorgung der elektronischen Steuerschaltung, beispielsweise für die Drehzahlsteuerung des Elektrowerkzeugs, notwendigen Verbindungsleitungen in dem einen Fixierelement anzuordnen. In diesem Fall weist das modulartige Verbindungselement mehrere, insbesondere vier Stifte auf. Zweckmäßigerweise kann das Fixierelement in etwa U-förmig ausgebildet sein, wobei die vier Stifte in etwa an den Ecken des U's angeordnet sind.

Aufgrund der modulartigen Ausgestaltung des Verbindungselements läßt sich dieses, insbesondere bei der Herstellung der Platine für die Steuerschaltung, direkt am Bestückungsautomaten bestücken und in der Lötanlage löten, laserverschweissen, widerstandsverschweissen oder in sonstiger Weise mit der Kontaktfläche elektrisch verbinden. Das Fixierelement hält dabei den Stift in Position und garantiert eine exakte Lage des Verbindungselements auf der Steuerschaltung. Das modulartige Verbindungselement kann dabei vorteilhafterweise komplett im Mehrfachnutzen bestückt und gelötet werden.

Das Fixierelement kann in einfacher Weise in der Art eines Rahmens ausgestaltet sein, der sich mittels eines Bestückungsautomaten gut handhaben läßt. Bevorzugterweise besteht das Fixierelement aus Kunststoff. Bei der Herstellung des Fixierelements durch Spritzgießen läßt sich gleichzeitig der Stift in das Fixierelement einspritzen, was Fertigungsschritte sowie Kosten einspart.

Zur Leitung von höheren elektrischen Strömen bietet es sich an, daß der Stift aus Kupfer besteht. Der Stift kann bereits oberflächlich verzinnt sein. Der Stift weist an dem der Kontaktfläche zugewandten einen Ende einen Kontaktteller auf, so daß das Verbindungselement bereits bei der Herstellung der Platine für die Steuerschaltung mittels des Kontakttellers auf der entsprechenden Kontaktfläche der Platine befestigt ist. Bei der Montage der Platine für die Steuerschaltung im Schalter wird dann der Stift des bereits auf der Platine befindlichen Verbindungselements mit seinem anderen Ende auf die Zuleitung aufgesteckt, wozu zweckmäßigerweise in der Zuleitung entsprechende Öffnungen, Bohrungen, Durchbrüche, Aufnahmen o. dgl. befindlich sind. Anschließend wird dann der Stift mit der Zuleitung verlötet, insbesondere selektiv gelötet, laserverschweißt, widerstandsverschweißt o. dgl., so daß erst am Ende der Montagekette die vollständige Platine für die Steuerschaltung und der restliche vormontierte Schalter, der das Kontaktsystem enthält, zusammengefügt und elektrisch verbunden werden. Vorteilhafterweise lassen sich dabei die erforderlichen Lötstellen außerhalb des Schalters anordnen, womit Verschmutzungen oder Schädigungen benachbarter Bereiche vermieden werden. Bedingt durch die konsequente Löt- und/oder Schweißtechnik am elektrischen Verbindungselement sind die Übergangswiderstände sehr gering, wodurch auch bei höheren fließenden Strömen, wie sie beispielsweise bei Akku-Elektrowerkzeugen auftreten, die Erwärmung des Schalters vermindert ist.

Die Zuleitung, über die die elektrische Spannung für den elektrischen Schalter zugeführt ist, kann in der Art eines Stanzgitters ausgebildet sein. Ein solches Stanzgitter ist auch für höhere Ströme geeignet. Die Zuleitung steht zum einen mit dem Kontaktsystem des Schalters sowie gegebenenfalls zum anderen über den Stift mit der Steuerschaltung des elektrischen Schalters in Verbindung. Da die elektrischen und/oder elektronischen Bauteile, beispielsweise eine Freilaufdiode, ein Leistungstransistor o. dgl., für die Steuerschaltung auf einer Leiterplatte angeordnet sind, bietet es sich an, daß die Kontaktfläche in der Art einer Leiterbahn auf der Leiterplatte ausgebildet ist. Beispielsweise kann es sich bei einer solchen leiterbahnartigen Kontaktfläche um ein hontaktpad auf der Leiterplatte handeln. Dann lassen sich die Stifte entsprechend dem Layout der Steuerschaltung so im Fixierelement anordnen, dass sie sich in unmittelbarer Nähe der Kontaktflächen für die Anschlüsse der elektrischen und/oder elektronischen Leistungsbauteile in der Steuerschaltung befinden. Dadurch muß der hohe Strom, der durch die Leistungsbauteile fließt, nur über sehr kurze Strecken über die Leiterbahnen auf der Platine der Steuerschaltung geführt werden, womit der Gefahr einer thermischen Beeinträchtigung der Steuerschaltung begegnet ist.

Um eine einfache Bestückung mittels eines Automaten zu ermöglichen, handelt es sich bei den elektrischen und/oder elektronischen Bauteile für die Steuerschaltung um solche, die in SMD(Surface Mounted Device)-Technik verarbeitbar sind. Es bietet sich dann weiter an, die Kontaktfläche für das elektrische und/oder elektronische Bauteil als ein direkt auf und/oder an dem Bauteil befindlicher SMD-Anschluß auszubilden. Der zum Anschluß des Bauteils führende Stift des Verbindungselements ist dann bei Bedarf derart verkürzt ausgestaltet, daß der Stift direkt auf dem Bauteil endet. Ein solcherart verkürzter Stift sitzt beispielsweise direkt auf der in Sandwichbauform aufgebauten Freilaufdiode der Steuerschaltung.

In einer Weiterbildung dient die Platine für die Steuerschaltung neben ihrer Funktion als Leiterplatte beziehungsweise Träger gleichzeitig als Kühlkörper und als Abdeckung für das gesamte Gehäuse des Schalters. Hierzu besteht die Leiterplatte aus einem Metallteil, wobei die Oberfläche des Metallteils an der Bestückungsseite für die elektrischen und/oder elektronischen Bauteile mit einer elektrischen Isolierschicht versehen ist und sich die Leiterbahnen auf der elektrischen Isolierschicht befinden. Das Metallteil ist an einer Außenseite am Gehäuse des Schalters entsprechend dem sonst üblichen Kühlkörper angeordnet. In einfacher Weise ist das Metallteil am Gehäuse mittels einer federelastischen Klammer befestigt, so daß die Leiterplatte neben der halternden Lötverbindung des Verbindungselements an der Zuleitung zusätzlich durch diese Klammer festgehalten ist. Zur weiteren Verbesserung der Wärmeableitung kann die Klammer noch als ein federndes, zusätzliches Kühlkörperelement ausgestaltet sein.

Neben den bereits genannten Fortschritten bestehen die mit der Erfindung erzielten Vorteile insbesondere darin, daß der elektrische Schalter aus zwei an sich getrennten Einheiten zusammengesetzt ist, nämlich aus der elektronischen Steuerschaltung sowie dem Kontaktsystem. Diese beiden Einheiten können separat vormontiert werden, wobei das Verbindungselement bereits bei der Herstellung der Steuerschaltung in dem herkömmlichen Bestückungsautomaten sowie der Lötanlage angebracht wird. Am Ende des Montageprozesses werden dann die beiden Einheiten mittels des Verbindungselements durch eine hochstromgeeignete Verbindungstechnik zum kompletten Schalter zusammengefügt. Das erfindungsgemäße Verbindungselement ist kostengünstig und zuverlässig herstellbar.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: einen elektrischen Schalter in einer ersten perspektivischen Ansicht,
- Fig. 2: den elektrischen Schalter in einer zweiten perspektivischen Ansicht,
- Fig. 3: den elektrischen Schalter ohne Gehäuse, jedoch mit der Steuerschaltung sowie Teilen der Spannungsführung,

- Fig. 4: den elektrischen Schalter mit Spannungsführung, jedoch ohne Gehäuse sowie mit entfernter Steuerschaltung, und
- Fig. 5: die Steuerschaltung des elektrischen Schalters.

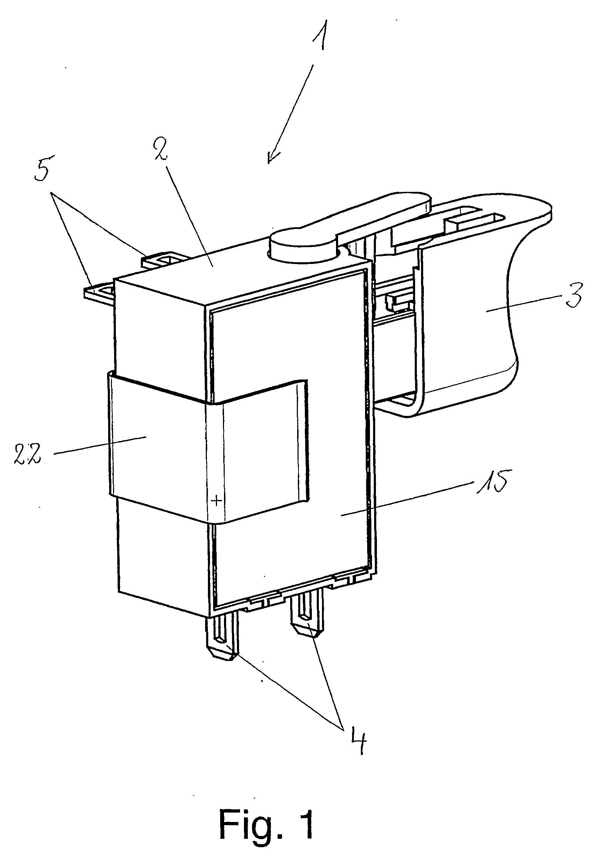

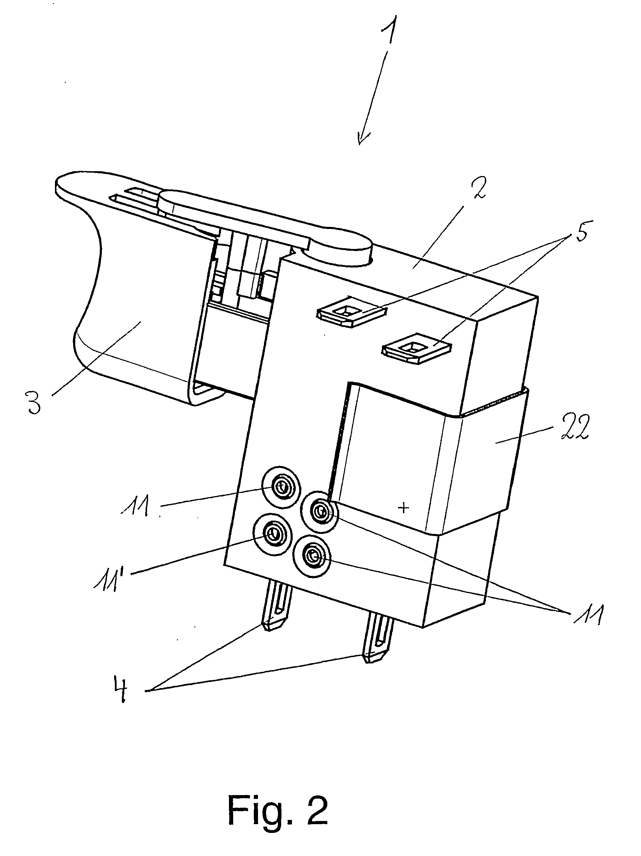

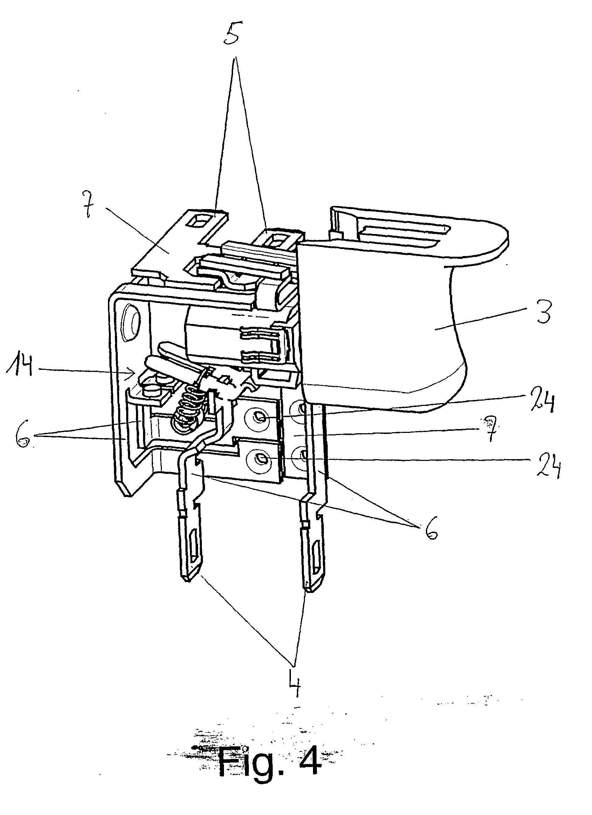

In Fig. 1 ist ein elektrischer Schalter 1 für ein Elektrowerkzeug, bei dem es sich um ein mit Gleichspannung betriebenes Akku-Elektrowerkzeug handelt, gezeigt. Der Schalter 1 besitzt ein Gehäuse 2, an dem ein vom Benutzer zu bedienendes Betätigungsorgan 3 in der Gestalt eines Drückers angeordnet ist. Durch Bewegung des Betätigungsorgans 3 wird der Motor des Elektrowerkzeugs eingeschaltet und dessen Drehzahl entsprechend der Stellung des Betätigungsorgans 3 eingestellt. Der Schalter 1 besitzt elektrische Eingangsanschlüsse 4, an denen die elektrische Spannung des Akkus angeschlossen ist, sowie in Fig. 2 sichtbare elektrische Ausgangsanschlüsse 5, an denen die elektrische Spannung für den Betrieb des Elektromotors des Elektrowerkzeugs anliegt. Wie in Fig. 4 zu sehen ist, wird die elektrische Spannung von den Eingangsanschlüssen 4, die am Akku angeschlossen sind, mittels Zuleitungen 6 in das Innere des Gehäuses 2 sowie im Inneren des Gehäuses 2 geführt. Die elektrische Spannung zum Betrieb des Elektromotors wird wiederum mittels Zuleitungen 7 im Inneren des Gehäuses 2 sowie aus dem Inneren des Gehäuses 2 zu den Ausgangsanschlüssen 5 geführt.

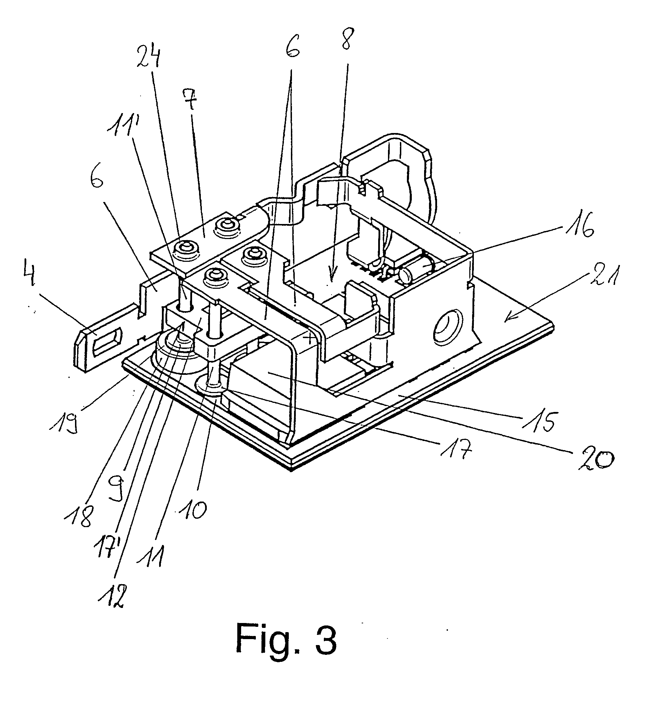

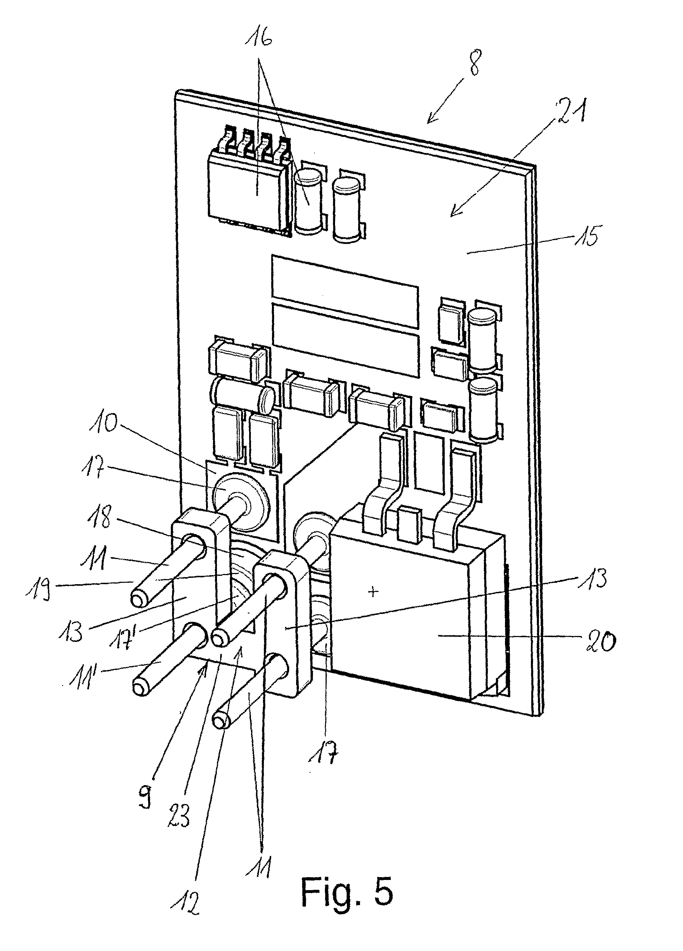

Zur Ansteuerung des Elektromotors mit der entsprechenden Drehzahl besitzt der Schalter 1 eine als Pulsweitenmodulations-Schaltung ausgebildete elektronische Steuerschaltung 8, die in Fig. 3 sowie Fig. 5 zu sehen ist. Die elektrische Spannung für die Steuerschaltung 8 wird entsprechend der Fig. 3 von den Zuleitungen 6 über ein elektrisches Verbindungselement 9 der Steuerschaltung 8 zugeführt. Zudem dient das Verbindungselement 9 auch zur Zuführung der von der Steuerschaltung 8 gelieferten Spannung für den Betrieb des Elektromotors an die Zuleitungen 7.

Wie weiter der Fig. 3 zu entnehmen ist, ist das elektrische Verbindungselement 9 zwischen einer Kontaktfläche 10 in der Steuerschaltung 8 und der elektrischen Zuleitung 6, 7 angeordnet. Das Verbindungselement 9 ist als ein für die Weiterverarbeitung selbständig handhabbares Modul ausgestaltet und weist wenigstens einen aus Metall bestehenden Stift 11 in der Art eines Lötstifts sowie ein aus einem elektrisch nichtleitenden Material bestehendes Fixierelement 12 auf. Der Stift 1 ist derart im Fixierelement 12 befestigt, daß der Stift 11 zu der zugehörigen Kontaktfläche 10 sowie der Zuleitung 6, 7 ausgerichtet ist. Weiterhin ragt der Stift 11 beidseitig aus dem Fixierelement 12 zur Kontaktierung mit der Kontaktfläche 10 sowie der Zuleitung 6, 7 heraus. Vorliegend dient das elektrische Verbindungselement 9 nicht nur zur Verbindung mit den Zuleitungen 6, wie bereits erwähnt, sondern auch mit den weiteren Zuleitungen 7, so daß das Verbindungselement 9 insgesamt vier Stifte 11 aufweist.

Die Kontaktierung des Stifts 11 mit der Kontaktfläche 10 erfolgt in der Art von SMD(Surface Mounted Device)-Technik, wozu der Stift 11 an dem der Kontaktfläche 10 zugewandten einen Ende einen flach ausgestalteten Kontaktteller 17 besitzt. Damit ist das modulartige elektrische Verbindungselement 9 mittels eines SMD-Bestückungsautomaten bei der Herstellung der Steuerschaltung 8 wie ein sonstiges SMD-Bauteil montierbar.

Das Fixierelement 12 ist in der Art eines in etwa U-förmigen Rahmens mit zwei Schenkeln 13 und einer Basis 23 zur Aufnahme der Stifte 11 ausgestaltet, wie anhand von Fig. 5 zu erkennen ist. Die Schenkel 13, die Basis 23 sowie die Anordnung der Stifte 11 ist entsprechend dem Layout der Kontaktflächen 10 in der Steuerschaltung 8 vorgenommen. Vorliegend befinden sich die Stifte 11 im wesentlichen in den Ecken des vom Fixierelement 12 gebildeten U's. Das Fixierelement 12 besteht aus Kunststoff, wobei die Stifte 11 in das Fixierelement 12 eingespritzt sind, indem die Stifte 11 mit dem Kunststoff des Fixierelements 12 umspritzt werden. Der Stift 11 besteht aus Kupfer, wobei der Stift 11 bereits bei der Herstellung des Verbindungselements 9 zwecks einfacher Weiterverarbeitung oberflächlich verzinnt werden kann. Nach Bestückung des Verbindungselements 9 bei der Herstellung der Steuerschaltung 8 wird dann der Stift 11 am Kontaktteller 17 mit der Kontaktfläche 10 verlötet, beispielsweise selektiv gelötet. Selbstverständlich kann anstelle einer Lötverbindung der Stift 11 auch laserverschweißt, widerstandsverschweißt o. dgl. mit der Kontaktfläche 10 sein. Somit liegt dann die das Verbindungselement 9 enthaltende Steuerschaltung 8 als separate Einheit in der Art einer Platine, eines Dickschichtmoduls o. dgl. entsprechend der Fig. 5 vor.

Wie anhand von Fig. 4 zu sehen ist, ist die Zuleitung 6, 7 in der Art eines Stanzgitters aus gut leitfähigem Metall, beispielsweise Kupfer ausgebildet, um die im Schalter 1 fließenden hohen Ströme aufnehmen zu können. Die Zuleitungen 6, 7 stehen auch direkt mit dem Kontaktsystem 14 des Schalters 1 in Verbindung, wobei die Zuleitungen 6, 7 mit dem Kontaktsystem 14 ebenfalls eine separate Einheit gemäß Fig. 4 bilden. Bei der Endmontage des Schalters 1 wird diese aus den Zuleitungen 6, 7 mitsamt dem Kontaktsystem 14 bestehende Einheit mit der weiteren Einheit, nämlich mit der Steuerschaltung 8, zusammengefügt, indem der Stift 11 mit seinem dem Kontaktteller 17 abgewandten anderen Ende auf die Zuleitung 6, 7 aufgesteckt wird. Hierzu ist das andere Ende des Stiftes 11 domartig ausgestaltet und greift in eine korrespondierende Öffnung 24, Bohrung, Durchbruch oder Aufnahme an der Zuleitung 6, 7 ein, wie in Fig. 3 zu sehen ist. Erforderlichenfalls wird anschließend dieses andere Ende des Stiftes 11 mit der Zuleitung 6, 7 verlötet, insbesondere selektiv gelötet. Selbstverständlich kann anstelle einer Verlötung wiederum laserverschweißt, widerstandsverschweißt o. dgl. werden. Damit ist dann mittels des Verbindungselementes 9 nicht nur eine mechanische sondern auch eine elektrische Verbindung der beiden Einheiten bewirkt. Schließlich werden die beiden zusammengefügten Einheiten noch mit dem Gehäuse 2 versehen und zum fertigen Schalter 1 komplettiert.

Wie anhand der Fig. 5 zu sehen ist, besitzt die Steuerschaltung 8 eine Leiterplatte 15, auf der die elektrischen und/oder elektronischen Bauteile 16 für die Steuerschaltung angeordnet sind. Die Kontaktfläche 10 ist in der Art einer Leiterbahn, und zwar als Kontaktpad, auf der Leiterplatte 15 ausgebildet. Die in Fig. 3 sichtbare Freilaufdiode 18 ist als ein SMD(Surface Mounted Device)-Bauteil ausgestaltet. Somit befindet sich bei der Freilaufdiode 18 der eine elektrische Anschluß 19, der in der Art eines SMD(Surface Mounted Device)-Anschlusses ausgestaltet ist, an der Oberseite der Freilaufdiode 18. Dieser Anschluß 19 wird ebenfalls als Kontaktfläche für das Verbindungselement 9 verwendet. Hierzu ist der zum Anschluß 19 der Freilaufdiode 18 führende Stift 11' derart verkürzt ausgestaltet, daß der Stift 11' mit seinem Kontaktteller 17' direkt auf beziehungsweise an dem Anschluß 19 an der Freilaufdiode 18 endet. Der Kontaktteller 17' ist wiederum in üblicher Weise mit dem Anschluß 19 verlötet. Selbstverständlich kann in entsprechender Weise auch der Anschluß von weiteren elektrischen und/oder elektronischen Bauteilen 16, beispielsweise falls gewünscht derjenige für den Leistungstransistor 20, ausgebildet sein.

In einer Weiterbildung, die eine besonders effektive Wärmeabfuhr aus dem Schalter 1 gestattet, ist die Leiterplatte 15 selbst ein Teil des Gehäuses 2, was anhand der Fig. 1 zu erkennen ist. Hierzu besteht die Leiterplatte 15 für die Steuerschaltung 8 aus einem Metallteil, wobei die in Fig. 5 sichtbare Oberfläche 21 des Metallteils an der Bestückungsseite für die elektrischen und/oder elektronischen Bauteile 16 mit einer elektrischen Isolierschicht versehen ist. Auf der elektrischen Isolierschicht befinden sich dann auch die Leiterbahnen zur elektrischen Verbindung der Bauteile 16 in der Steuerschaltung 8. Das Metallteil der Leiterplatte 15 ist an einer Außenseite am Gehäuse 2 des Schalters 1 derart angeordnet, daß das Metallteil neben seiner Funktion als Leiterplatte 15 gleichzeitig als Kühlkörper sowie als Abdeckung für das Gehäuse 2 dient. Eine fertigungstechnisch einfache Befestigung des Metallteils der Leiterplatte 15 läßt sich erzielen, indem dieses am Gehäuse 2 mittels einer federelastischen Klammer 22 befestigt ist. Zur nochmaligen Verbesserung der Wärmeabfuhr läßt sich auch die Klammer als ein zusätzliches federndes Kühlkörperelement ausgestalten.

Die Erfindung ist nicht auf das beschriebene und dargestellte Ausführungsbeispiel beschränkt. Sie umfaßt vielmehr auch alle fachmännischen Weiterbildungen im Rahmen der durch die Patentansprüche definierten Erfindung. So kann das erfindungsgemäße Verbindungselement 9 nicht nur in Elektrowerkzeugschaltern für Akkugeräte sondern auch an Schaltern für Wechselspannungsgeräte, bei denen die Steuerschaltung beispielsweise als Phasenanschnitt-Steuerung ausgebildet ist, Verwendung finden. Auch in sonstigen Elektrogeräten, beispielsweise in Steuergeräten für Kraftfahrzeuge, in Haushaltsgeräten, in Unterhaltungselektronikgeräten, in Datenverarbeitungsgeräten o. dgl. läßt sich das Verbindungselement vorteilhaft einsetzen.

### Bezugszeichen-Liste:

- 1:: elektrischer Schalter
- 2:: Gehäuse
- 3:: Betätigungsorgan
- 4:: Eingangsanschluß
- 5:: Ausgangsanschluß
- 6,7:: Zuleitung
- 8:: Steuerschaltung
- 9:: Verbindungselement
- 10:: Kontaktfläche
- 11,11':: Stift
- 12:: Fixierelement
- 13:: Schenkel (von Fixierelement)
- 14:: Kontaktsystem
- 15:: Leiterplatte
- 16:: (elektrisches und/oder elektronisches) Bauteil
- 17,17':: Kontaktteller (an Stift)
- 18:: Freilaufdiode
- 19:: Anschluß (von Freilaufdiode)
- 20:: Leistungstransistor
- 21:: Oberfläche (der Leiterplatte)
- 22:: Klammer
- 23:: Basis (von Fixierelement)
- 24:: Öffnung (in Zuleitung)

## Patentansprüche

1. Elektrischer Schalter für ein Elektrowerkzeug, wie für ein Akku-Elektrowerkzeug, mit einer elektrischen Zuleitung (6, 7) und mit einer elektronischen Steuerschaltung (8), wobei ein elektrisches Verbindungselement (9) zwischen einer Kontaktfläche (10) für die Steuerschaltung (8) sowie der Zuleitung (6, 7) angeordnet ist, **dadurch gekennzeichnet, daß** das elektrische Verbindungselement (9) wenigstens einen aus Metall bestehenden Stift (11) aufweist, daß der Stift (11) in einem aus einem elektrisch nichtleitenden Material bestehenden Fixierelement (12) derart befestigt ist, daß der Stift (11) zu der zugehörigen Kontaktfläche (10) sowie der Zuleitung (6, 7) ausgerichtet ist, und daß der Stift (11) beidseitig aus dem Fixierelement (12) zur Kontaktierung, gegebenenfalls in der Art von SMD(Surface Mounted Device)-Technik, mit der Kontaktfläche (10) sowie der Zuleitung (6, 7) herausragt.

2. Elektrischer Schalter nach Anspruch 1, **dadurch gekennzeichnet, daß** das Fixierelement (12) aus Kunststoff besteht, daß vorzugsweise das Fixierelement (12) in der Art eines Rahmens ausgestaltet ist, daß weiter vorzugsweise der Stift (11) in das Fixierelement (12) eingespritzt ist, und daß noch weiter vorzugsweise mehrere Stifte (11), insbesondere vier Stifte (11), im Fixierelement (12), das gegebenenfalls in etwa U-förmig ausgebildet ist, befestigt sind.

3. Elektrischer Schalter nach Anspruch 1 oder 2, **dadurch gekennzeichnet, daß** der Stift (11) aus Kupfer besteht, wobei insbesondere der Stift (11) oberflächlich verzinnt ist, daß vorzugsweise der Stift (11) an dem der Kontaktfläche (10) zugewandten einen Ende einen Kontaktteller (17) aufweist, daß weiter vorzugsweise der Stift (11) auf die Zuleitung (6, 7), insbesondere in einer an der Zuleitung (6, 7) befindlichen Öffnung (24), einer Bohrung, einem Durchbruch, einer Aufnahme o. dgl., aufgesteckt ist, und daß noch weiter vorzugsweise der Stift (11) mit der Kontaktfläche (10), insbesondere mittels des Kontakttellers (17), und/oder der Zuleitung (6, 7) verlötet, insbesondere selektiv gelötet, laserverschweißt, widerstandsverschweißt o. dgl. ist.

4. Elektrischer Schalter nach Anspruch 1, 2 oder 3, **dadurch gekennzeichnet, daß** die Zuleitung (6, 7) in der Art eines Stanzgitters ausgebildet ist, daß vorzugsweise die elektrische Spannung für den elektrischen Schalter (1) über die Zuleitung (6, 7) geführt ist, und daß weiter vorzugsweise die Zuleitung (6, 7) mit dem Kontaktsystem (14) des Schalters (1) sowie gegebenenfalls über den Stift (11) mit der Steuerschaltung (8) des elektrischen Schalters (1) in Verbindung steht.

5. Elektrischer Schalter nach einem der Ansprüche 1 bis 4, **dadurch gekennzeichnet, daß** die Kontaktfläche (10) in der Art einer Leiterbahn, insbesondere als Kontaktpad, auf einer Leiterplatte (15) ausgebildet ist, und daß vorzugsweise auf der Leiterplatte (15) die elektrischen und/oder elektronischen Bauteile (16) für die Steuerschaltung (8) angeordnet sind.

6. Elektrischer Schalter nach einem der Ansprüche 1 bis 5, **dadurch gekennzeichnet, daß** die Kontaktfläche. (10) als Anschluß, insbesondere in der Art eines SMD(Surface Mounted Device)-Anschlusses, für das elektrische und/oder elektronische Bauteil (16), bei dem es sich beispielsweise um eine E'reilaufdiode (18), einen Leistungstransistor (20) o. dgl. handelt, ausgebildet ist, und daß vorzugsweise der zum Anschluß des Bauteils (16, 18, 20) führende Stift (11') derart verkürzt ausgestaltet ist, daß der Stift (11'), insbesondere mittels seines Kontakttellers (17'), direkt am Anschluß auf und/oder an dem Bauteil (16, 18, 20) endet.

7. Elektrischer Schalter nach einem der Ansprüche 1 bis 6, **dadurch gekennzeichnet, daß** die Leiterplatte (15) aus einem Metallteil besteht, wobei die Oberfläche (21) des Metallteils an der Bestückungsseite für die elektrischen und/oder elektronischen Bauteile (16) mit einer elektrischen Isolierschicht versehen ist, daß vorzugsweise die Leiterbahnen auf der elektrischen Isolierschicht befindlich sind, daß weiter vorzugsweise das Metallteil an einer Außenseite am Gehäuse (2) des Schalters (1) derart angeordnet ist, daß das Metallteil neben seiner Funktion als Leiterplatte gleichzeitig als Kühlkörper sowie als Abdeckung für das Gehäuse (2) dient, und daß noch weiter vorzugsweise das Metallteil am Gehäuse (2) mittels einer federelastischen Klammer (22), die gegebenfalls als federndes Kühlkörperelement ausgestaltet ist, befestigt ist.

8. Verfahren zur Herstellung eines elektrischen Schalters (1) nach einem der voranstehenden Ansprüche, **dadurch gekennzeichnet, daß** das Verbindungselement (9) bei der Herstellung der Steuerschaltung (8) angebracht wird, derart daß eine separate, vormontierte Einheit in der Art einer Platine, eines Dickschichtmoduls o. dgl. vorliegt, daß die Zuleitung (6, 7) mit dem Kontaktsystem (14) als weitere separate, vormontierte Einheit hergestellt wird, und daß anschließend bei der Endmontage die beiden Einheiten mittels des Verbindungselements (9) zum kompletten Schalter (1) zusammengefügt werden.

## Claims

1. Electric switch for an electric tool, such as battery-powered electrical tool, with an electric feeder line (6, 7) and an electronic control circuit (8), wherein an electric connecting element (9) is arranged between a contact surface (10) for the control circuit (8) and the feeder line (6, 7), **characterised in that** the electric connecting element (9) comprises at least one pin (11) made of metal, **in that** the pin (11) is fixed into a securing element (12) made of a non-electricity conducting material, so that the pin (11) is aligned relative to the associated contact surface (10) and the feeder line (6, 7), and **in that** the pin (11) protrudes on both sides of the securing element (12) for contacting, if applicable as in SMD (Surface Mounted Device) technology, with the contact surface (10) and the feeder line (6, 7).

2. Electric switch according to claim 1, **characterised in that** the securing element (12) is made of plastic, **in that** preferably the securing element (12) is designed in the form of a frame, **in that** also preferably the pin (11) is injected into the securing element (12), and **in that** also preferably several pins (11), in particular four pins (11) are fixed in the securing element (12), which if necessary is designed to be U-shaped.

3. Electric switch according to claim 1 or 2, **characterised in that** the pin (11) is made of copper, whereby in particular the pin (11) is tin-coated on the surface, **in that** preferably the pin (11) has a contact disc (17) at the end facing the contact surface (10), **in that** also preferably the pin (11) is fitted into the feeder line (6, 7), in particular through an opening (24), a bore, a through hole, a slot or the like in the feeder line (6, 7), and **in that** also preferably the pin (11) is welded to the contact surface (10), in particular by means of the contact disc (17) and/or the feeder line (6, 7), in particular is welded selectively, laser welded, resistance welded or the like.

4. Electric switch according to claim 1, 2 or 3, **characterised in that** the feeder line (6, 7) is designed in the form of a blanking skeleton, **in that** preferably the voltage for the electric switch (1) is fed through the feeder line (6, 7), and **in that** also preferably the feeder line (6, 7) is in contact with the contact system (14) of the switch (1) and if necessary via the pin (11) with the control circuit (8) of the electric switch (1).

5. Electric switch according to one of claims 1 to 4, **characterised in that** the contact surface (10) is designed in the form of a conductor path, in particular a contact path, on a circuit board (15), and **in that** preferably the electric and/or electronic components (16) for the control circuit (8) are arranged on the circuit board (15).

6. Electric switch according to one of claims 1 to 5, **characterised in that** the contact surface (10) is designed as a connection, in particular as an SMD (Surface Mounted Device) connection, for the electric and/or electronic component (16), which is for example a free-wheeling diode (18), a power transistor (20) or the like, and **in that** preferably the pin (11') leading to the connection of the component (16, 18, 20) is designed to be shortened, so that the pin (11'), in particular via its contact disc (17') ends directly at the connection with and/or on the component (16, 18, 20).

7. Electric switch according to one of claims 1 to 6, **characterised in that** the circuit board (15) is made from a metal part, whereby the surface (21) of the metal part is provided with an electric insulating layer on the side for inserting the electric and/or electronic components (16), **in that** preferably the conductor paths are located on the electric insulating layer, **in that** also preferably the metal part is arranged on the outside of the housing (2) of the switch (1) such that the metal part is used as well as a circuit board as a cooling body and as a cover for the housing (2), and **in that** also preferably the metal part is secured onto the housing (2) by means of a resilient clamp (22), which if applicable is designed as a resilient heat sink element.

8. Method for the production of an electric switch (1) according to one of the above claims, **characterised in that** the connecting element (9) is attached during the production of the control circuit (8), so that a separate, preassembled unit is provided in the form of a printed circuit board, a thick film module or the like, **in that** the feeder line (6, 7) with the contact system (14) is produced as an additional, separate preassembled unit, and **in that** afterwards during the final assembly the two units are joined together by means of the connecting element (9) to form a complete switch (1).

## Revendications

1. Commutateur électrique pour un outil électrique, par exemple un outil électrique à accumulateur, comprenant une alimentation électrique (6, 7), un circuit de commande électronique (8), et un composant de connexion électrique (9) entre une surface de contact (10) pour le circuit de commande (8) et l'alimentation (6, 7),
**caractérisé en ce que**
le composant de connexion électrique (9) présente au moins une broche métallique (11),
la broche (11) est fixée dans un élément de fixation (12) constitué d'un matériau non conducteur électriquement de sorte à être orientée vers la surface de contact (10) associée et l'alimentation (6, 7), et
la broche (11) dépasse de part et d'autre de l'élément de fixation (12) pour la mise en contact avec la surface de contact (10) et l'alimentation (6, 7), le cas échéant selon la technique SMD (technologie des composants montés en surface).

2. Commutateur électrique selon la revendication 1,
**caractérisé en ce que**
l'élément de fixation (12) est en matière plastique,
l'élément de fixation (12) présente de préférence la forme d'un cadre,
la broche (11) est encore de préférence injectée dans l'élément de fixation (12), et
encore de préférence plusieurs broches (11), en particulier quatre broches (11), sont fixées dans l'élément de fixation (12) qui le cas échéant présente approximativement la forme de U.

3. Commutateur électrique selon la revendication 1 ou 2,
**caractérisé en ce que**
la broche (11) est en cuivre, en particulier la broche (11) étant étamée superficiellement,
à l'extrémité tournée vers la surface de contact (10), la broche (11) présente de préférence une rondelle de contact (17),
la broche (11) est encore de préférence emboîtée sur l'alimentation (6, 7), en particulier dans une ouverture (24), un alésage, un passage, un logement ou similaire situé au niveau de l'alimentation (6, 7), et
encore de préférence la broche (11) est brasée, en particulier de manière sélective, soudée par laser, soudée par résistance ou similaire avec la surface de contact (10), en particulier au moyen de la rondelle de contact (17), et/ou avec l'alimentation (6, 7).

4. Commutateur électrique selon la revendication 1, 2 ou 3,
**caractérisé en ce que**
l'alimentation (6, 7) présente la forme d'un grillage estampé,
la tension électrique pour le commutateur électrique (1) arrive de préférence par l'alimentation (6, 7), et
encore de préférence l'alimentation (6, 7) est reliée au système de contact (14) du commutateur (1) ainsi que, le cas échéant, au circuit de commande (8) du commutateur électrique (1) par l'intermédiaire de la broche (11).

5. Commutateur électrique selon l'une quelconque des revendications 1 à 4,
**caractérisé en ce que**
la surface de contact (10) est formée sur un circuit imprimé (15) sous forme d'une piste conductrice, en particulier d'une piste de contact, et
les composants électriques et/ou électroniques (16) pour le circuit de commande (8) sont de préférence disposés sur le circuit imprimé (15).

6. Commutateur électrique selon l'une quelconque des revendications 1 à 5,
**caractérisé en ce que**
la surface de contact (10) présente la forme d'une borne, en particulier du type SMD (technologie des montages en surface), pour le composant électrique et/ou électronique (16) qui peut par exemple être une diode de roue libre (18), un transistor de puissance (20) ou similaire, et
la broche (11') s'étendant jusqu'à la borne du composant (16, 18, 20) est raccourcie de sorte qu'elle se termine, en particulier au moyen de sa rondelle de contact (17'), directement au niveau de la borne et/ou du composant (16, 18, 20).

7. Commutateur électrique selon l'une quelconque des revendications 1 à 6,
**caractérisé en ce que**
le circuit imprimé (15) est une pièce métallique, la surface (21) de la pièce métallique étant munie d'une couche d'isolation électrique sur la face recevant les composants électriques et/ou électroniques (16),
les pistes conductrices se situent de préférence sur la couche d'isolation électrique,
la pièce métallique est encore de préférence disposée sur une face extérieure sur le boîtier (2) du commutateur (1) de manière à non seulement assurer sa fonction de circuit imprimé mais également servir de corps de refroidissement ainsi que de couverture pour le boîtier (2), et
encore de préférence la pièce métallique est fixée au boîtier (2) au moyen d'une pince élastique (22) qui le cas échéant présente la forme d'un corps de refroidissement flexible.

8. Procédé de fabrication d'un commutateur électrique (1) selon l'une quelconque des revendications précédentes,
**caractérisé en ce que**
le composant de connexion (9) est monté lors de la fabrication du circuit de commande (8) pour ainsi obtenir une unité prémontée séparée sous forme d'une platine, d'un module à couche épaisse ou similaire,
l'alimentation (6, 7) est fabriquée avec le système de contact (14) sous forme d'une autre unité prémontée séparée, et
lors du montage final les deux unités sont ensuite assemblées au moyen du composant de connexion (9) pour obtenir le commutateur (1) complet.
